# FASCICULE DE BREVET EUROPEEN

(11) **EP 2 747 140 B1**
(45) Date de publication et mention de la délivrance du brevet: **20.11.2019**
(21) Numéro de dépôt: 13197816.5
(22) Date de dépôt: 17.12.2013
(51) Int. Cl.: H01L 29/06, B82Y 10/00, B82Y 40/00, H01L 29/16, H01L 21/02

(54) **Procédé d'obtention d'au moins un nanoélément à base de silicium dans une couche d'oxyde de silicium, et procédé de fabrication d'un dispositif éléctronique muni d'au moins un tel nanoélément.**
Verfahren zur Herstellung mindestens eines Nanoelements auf Siliziumbasis in einer Siliziumoxydschicht, und Herstellungsverfahren einer Vorrichtung mit mindestens einem solchen Nanoelement.
Method for producing at least one silicon nanoelement in a silicon oxide layer, and method for manufacturing a device comprising at least one such nanoelement.

(30) Priorité: 20.12.2012 FR 1262446
(43) Date de publication de la demande: 25.06.2014
(73) Titulaire: COMMISSARIAT À L'ÉNERGIE ATOMIQUE ET AUX ÉNERGIES ALTERNATIVES, 75015 Paris (FR)
(72) Inventeur: Larrey, Vincent, 38140 La Murette (FR); Vandroux, Laurent, 38570 Le Cheylas (FR); Berthelot, Audrey, 38330 St Ismier (FR); Vaudaine, Marie-Hélène, 38180 Seyssins (FR)
(74) Mandataire: Novaimo

(56) Documents cités:
- Jovan Matovic ET AL: "Nanomembrane: A New MEMS/NEMS Building Block" In: "Micro Electronic and Mechanical Systems", 1 décembre 2009 (2009-12-01), Intech, Rijeka, Croatia, XP055079727, ISBN: 978-9-53-307027-8 pages 61-84, * pages 76-78; figure 10 *
- WANG ET AL: "Growth of nanowires", MATERIALS SCIENCE AND ENGINEERING R: REPORTS, ELSEVIER SEQUOIA S.A., LAUSANNE, CH, vol. 60, no. 1-6, 5 mars 2008 (2008-03-05) , pages 1-51, XP022534062, ISSN: 0927-796X, DOI: 10.1016/J.MSER.2008.01.001
- NOOR MOHAMMAD S: "Investigation of the oxide-assisted growth mechanism for nanowire growth and a model for this mechanism", JOURNAL OF VACUUM SCIENCE AND TECHNOLOGY: PART B, AVS / AIP, MELVILLE, NEW YORK, NY, US, vol. 26, no. 6, 24 novembre 2008 (2008-11-24), pages 1993-2007, XP012114407, ISSN: 1071-1023, DOI: 10.1116/1.3002486
- DHARA S ET AL: "Self-catalytic growth of horizontal and straight Si nanowires on Si substrates using a sputter deposition technique", SOLID STATE COMMUNICATIONS, PERGAMON, GB, vol. 150, no. 39-40, 1 octobre 2010 (2010-10-01), pages 1923-1927, XP027253967, ISSN: 0038-1098 [extrait le 2010-07-23]

## Description

### Domaine technique de l'invention

L'invention concerne le domaine des nanotechnologies.

L'invention a pour objet plus particulièrement un procédé d'obtention d'un nanoélément, ou d'une pluralité de nanoéléments, à base de silicium.

### État de la technique

La plupart des procédés d'obtention de nanofils ou nanoéléments requièrent un précurseur métallique. Par exemple, des gouttelettes du précurseur sont formées sur un substrat de sorte à permettre, sous atmosphère contrôlée, la croissance de nanofils à l'interface entre le substrat et chaque gouttelette. Il en résulte une contamination métallique pouvant interdire l'utilisation de ces nanofils dans un procédé ultérieur incompatible avec ladite contamination.

Il existe donc un besoin de former des nanofils à base de silicium sans utilisation de précurseurs métalliques.

On connaît du document "Nanomembrane: A New MEMS/NEMS Building Block", de Jovan Matovic et al., une utilisation de carbone dans des nanomembranes.

On connaît du document "Growth of nanowires", de Wang et al., une utilisation de carbone sous forme de poudre dans du ZnO.

On connaît du document "Investigation of the oxide-assisted growth mechanism for nanowire growth and a model for this mechanism", de Noor Mohammad S et al., une utilisation d'une assistance à base d'oxyde pour la croissance de nanofils.

### Objet de l'invention

Le but de la présente invention est de proposer une solution qui remédie à l'inconvénient listé ci-dessus.

On tend vers ce but notamment en ce que le procédé d'obtention d'au moins un nanoélément à base de silicium, notamment un nanofil, comporte les étapes revendiquées dans la revendication 1.

Avantageusement, le silicium de la première couche est du silicium polycristallin.

De préférence, le procédé comporte une étape de dopage électrique de type n de la première couche par un phosphore avec une concentration comprise entre 10¹⁹ at.cm⁻³ et 2.10²⁰ at.cm⁻³ bornes inclues.

Selon une mise en œuvre le procédé comporte, avant le dopage de la première couche, une étape de détermination de la concentration voulue du dopant dans la première couche de sorte à obtenir une densité prédéterminée de nanoéléments consécutivement à l'étape d'exposition. Selon un premier exemple, l'étape de formation de la deuxième couche est réalisée un utilisant un précurseur contenant du carbone, notamment du TétraEthOxySilane, en utilisant la technique de dépôt chimique en phase vapeur assistée par plasma.

Selon un deuxième exemple préféré, l'étape de formation de la deuxième couche est réalisée en utilisant un précurseur ne comportant pas de carbone, notamment le précurseur est du silane, et en incorporant du carbone, notamment du dioxyde de carbone.

Avantageusement, l'étape d'exposition comporte une étape de maintien d'une température d'oxydation à laquelle sont soumises les première et deuxième couches et une étape d'injection d'un gaz oxydant, notamment de l'oxygène, dans une enceinte d'oxydation dans laquelle sont placées les première et deuxième couches. L'étape d'exposition peut être mise en œuvre pendant une durée prédéterminée fonction des conditions de température et d'utilisation du gaz oxydant.

Selon un mode d'exécution, ledit nanoélément étant recouvert au moins en partie consécutivement à sa formation lors de l'étape d'exposition, le procédé comprend une étape de dégagement d'au moins une partie recouverte dudit nanoélément.

Selon un exemple, l'étape de dégagement comprend une étape de suppression de l'oxyde de silicium de la deuxième couche et de la partie oxydée de la première tranche jusqu'à une deuxième tranche non oxydée issue de la première couche à partir de laquelle s'étend ledit au moins un nanoélément.

Selon un autre exemple, l'étape de dégagement comporte une étape de rabotage d'au moins la deuxième couche de sorte à libérer une extrémité dudit au moins un nanoélément.

L'invention est aussi relative à un procédé de fabrication d'un dispositif électronique muni d'au moins un nanoélément fonctionnalisé, ledit procédé comportant : une étape de mise en œuvre du procédé d'obtention tel que décrit de sorte à former ledit au moins un nanoélément, et une étape de fonctionnalisation dudit au moins un nanoélément de sorte à créer une interaction électrique dudit au moins un nanoélément avec un autre élément du dispositif.

De préférence, si ledit procédé d'obtention comporte une étape de rabotage d'au moins la deuxième couche de sorte à libérer une extrémité dudit au moins un nanoélément, l'étape de fonctionnalisation comprend le report d'une partie du dispositif au niveau de ladite extrémité libérée de sorte à associer à ladite extrémité libérée ledit autre élément du dispositif.

De préférence, si ledit procédé d'obtention comporte une étape de dégagement d'au moins une partie recouverte le long dudit nanoélément entre deux de ses extrémités longitudinales opposées, l'étape de fonctionnalisation comporte une étape de dépôt d'une couche destinée à former ledit autre élément du dispositif sur au moins une portion de ladite au moins une partie dégagée du nanoélément.

Selon une réalisation, ledit au moins un nanoélément étant associé à un premier substrat, et ledit autre élément étant associé à un deuxième substrat distinct du premier substrat, le procédé comporte une étape de transfert de l'un des substrats sur l'autre de sorte à associer ledit au moins un nanoélément audit autre élément.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- les figures 1 à 3 illustrent différentes vues en coupes de différentes étapes de réalisation du procédé d'obtention dudit au moins un nanoélément,
- les figures 4 et 5 illustrent, vus en coupe, deux modes d'exécution différents de dégagement dudit au moins un nanoélément,
- les figures 6 et 7 illustrent, vus en coupes, deux modes d'exécution différents du procédé de fabrication d'un dispositif électronique,
- la figure 8 illustre un mode d'exécution particulier présentant un substrat muni d'une tranchée en forme de serpentin,
- la figure 9 illustre une vue en coupe selon A-A de la figure 8 sur laquelle des étapes technologiques de dépôt de couches ont été réalisées,
- la figure 10 présente un dispositif de détection de gaz utilisant une partie de la figure 9 et refermé par un capot.

### Description de modes préférentiels de l'invention

Le procédé décrit ci-après diffère de l'art antérieur notamment en ce que le nanoélément est obtenu au cours d'une oxydation d'une couche en silicium dans des conditions particulières.

Dans la présente description, lorsqu'un élément est à base d'un matériau, cela signifie que ce matériau est présent en majorité par rapport aux autres matériaux composant ledit élément, ou qu'il constitue ledit élément.

Le terme 'nanoélément' ou 'nanofil' dans la suite de la description signifie préférentiellement une structure tridimensionnelle de forme allongée dont la dimension longitudinale est au moins égale à 10 fois la ou les dimensions transversales, de préférence au moins 50 fois et encore plus préférentiellement au moins 100 fois. La ou les dimensions transversales sont comprises entre 1 nm et 20 nm. Dans certains modes de réalisation, les dimensions transversales peuvent être inférieures ou égales à environ 10 nm, de préférence comprises entre 1 nm et 5 nm. Dans certains modes de réalisation, la hauteur de chaque nanofil peut être, de préférence, supérieure ou égale à 50 nm.

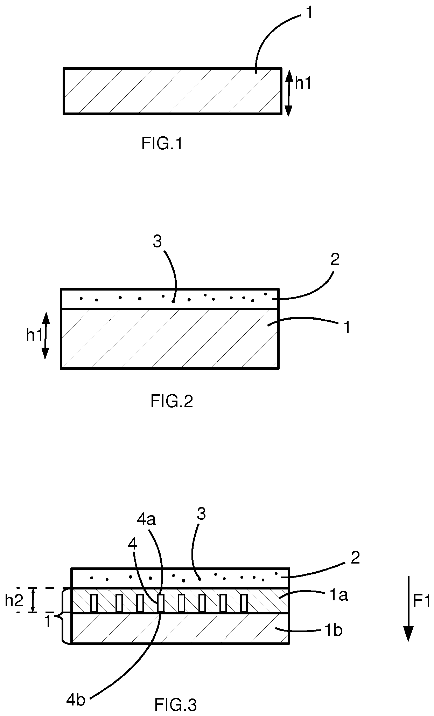

Comme illustré aux figures 1 à 3, le procédé d'obtention d'au moins un nanoélément à base de silicium, notamment un nanofil, comporte une étape dans laquelle il est fourni un substrat comprenant au moins en surface une première couche 1 comprenant du silicium électriquement dopé. Le dopage peut être de type n ou p, notamment tel que la première couche 1 est électriquement conductrice (par exemple en silicium dégénéré). La première couche 1 peut résulter du dépôt d'une couche, par exemple de polysilicium, à la surface d'un substrat de support (non représenté) par exemple en silicium. Dans ce cas, le dopage électrique peut avoir lieu pendant le dépôt ou après le dépôt de ladite première couche, par exemple par implantation.

En variante, la première couche 1 peut résulter du dopage en surface d'un substrat massif de silicium monocristallin ou polycristallin.

La première couche 1 peut avoir une épaisseur h1 comprise entre 100nm et 1µm, bornes de cette gamme d'épaisseur inclues.

Le procédé comporte en outre une étape de formation, sur la première couche 1, d'une deuxième couche 2 (figure 2) à base d'oxyde de silicium avec des atomes de carbone 3 dispersés dans la deuxième couche 2. L'oxyde de silicium de formule SiOₓ (dans des conditions de stœchiométrie ou non, typiquement avec 0<x≤2 et avantageusement 1,8≤x≤2) est aussi appelé dioxyde de silicium ou silice.

Enfin le procédé comporte une étape dans laquelle les première et deuxième couches 1, 2 sont exposées à une atmosphère oxydante de sorte à oxyder (figure 3) au moins une première tranche 1a de la première couche 1 à l'interface de ladite première couche 1 avec la deuxième couche 2 et à former ledit au moins un nanoélément 4 au niveau de ladite première tranche 1a. En fait, cette formation du nanoélément 4 se fait dans la première tranche 1a, chaque nanoélément peut alors être recouvert au moins en partie d'oxyde de silicium formant la première tranche 1a.

Par « tranche », on entend une partie d'une couche selon son épaisseur. Autrement dit, en référence à la figure 3, une tranche est inclue dans un plan sensiblement ou exactement perpendiculaire à la flèche F1. Le plan incluant une tranche est donc sensiblement ou exactement parallèle au plan incluant la couche de laquelle la tranche est issue (correspondant, le cas échéant, au plan du substrat de support).

La hauteur h2 de la première tranche 1a est fonction de la hauteur voulue du nanoélément 4. En effet, la hauteur h2 est légèrement supérieure à celle du nanoélément 4 du fait de l'expansion du silicium lors de son oxydation. Ainsi, le nanoélément 4 peut s'étendre entre une deuxième tranche 1b non oxydée restante de la première couche initiale 1 jusqu'à proximité de la deuxième couche 2.

Autrement dit, c'est l'oxydation de la première couche 1 qui génère de manière inattendue un ou plusieurs nanoéléments 4 au niveau de ladite première tranche 1a lorsque les conditions de substrat dopé, de couche en oxyde de silicium comprenant des atomes de carbone et d'exposition à l'atmosphère oxydante visées ci-dessus sont réunies.

De préférence et applicable aux différentes réalisations, le silicium de la première couche 1 est du silicium polycristallin, mais l'invention s'applique aussi à du silicium monocristallin en tant que première couche 1. Néanmoins, plus la densité de joints de grains est importante, plus la densité des nanoéléments 4 est importante, ces nanoéléments se localisant préférentiellement mais pas exclusivement au niveau des joints de grains.

Dans la présente description, par densité, on entend le nombre de nanoéléments 4 pour une unité de surface donnée, par exemple des cm².

Avantageusement, le procédé comporte une étape de dopage électrique, notamment du silicium, de ladite première couche 1, notamment de type n, par un phosphore de préférence avec une concentration comprise entre 10¹⁹ at.cm⁻³ et 2.10²⁰ at.cm⁻³ bornes inclues.

Le dopage du silicium de la première couche 1 a son importance dans le sens où si le dopage n'est pas réalisé, il n'est pas observé de formation de nanoélément(s) au cours de l'étape d'exposition pendant laquelle la première tranche 1a est formée. Par ailleurs, il a été constaté que la variation du dopage du silicium pouvait faire varier, de manière indépendante du reste des conditions du procédé, la densité d'apparition de nanoéléments 4 au cours de l'étape d'exposition. Ainsi, plus le dopage est élevé, plus la densité de nanoéléments 4 est élevée. Ainsi, le procédé peut avantageusement comporter, avant le dopage (électrique) de la première couche 1, une étape de détermination de la concentration voulue du dopant dans la première couche 1, notamment dans le silicium de la première couche, de sorte à obtenir une densité prédéterminée de nanoéléments 4 consécutivement à l'étape d'exposition.

En particulier, l'homme du métier saura adapter le dopage du silicium de la première couche 1 en fonction de la densité de nanoéléments souhaitée avec une gamme de dopage selon l'invention entre 10¹⁸ at.cm⁻³ et 10²¹ at.cm⁻³, avantageusement entre 10¹⁹ at.cm⁻³ et 5.10²⁰ at.cm⁻³, et par exemple entre 10¹⁹ at.cm⁻³ et 10²⁰ at.cm⁻³.

Comme évoqué précédemment, la deuxième couche à base d'oxyde de silicium doit contenir du carbone. Ce carbone peut être introduit lors d'un dépôt de la deuxième couche 2, ou après le dépôt de la deuxième couche 2 par exemple par implantation. On comprend donc que l'étape de formation peut comporter une étape de dépôt réalisant la deuxième couche dans laquelle des atomes de carbone sont dispersés ou une étape de dépôt d'une couche intermédiaire suivie d'une étape d'implantation permettant la dispersion d'atomes de carbone dans la couche intermédiaire de sorte à former après dispersion ladite couche deuxième couche. Ces atomes de carbone 3 ont aussi leur importance dans le sens où si la deuxième couche 2 ne comporte pas d'atomes de carbone 3, il n'est pas observé de formation de nanoélément(s) au cours de l'étape d'exposition. Plus la quantité de carbone est importante, plus la densité de nanoéléments 4 est importante. Par ailleurs, au-delà d'un certain seuil de carbone, il a été constaté que les nanoéléments 4 pouvaient même s'agglomérer au sein de l'oxyde.

Selon l'invention, la deuxième couche 2 comporte un pourcentage atomique de carbone minimal de 0.1%, par exemple supérieur à 0.2% ou 0.4% ou 0.5% et un pourcentage atomique de carbone maximal de 10%, par exemple inférieur à 5%.

Ces atomes de carbone 3 peuvent être apportés de plusieurs manières différentes notamment dans une enceinte contrôlée de dépôt de la deuxième couche 2.

Dans un premier exemple permettant la présence des atomes de carbone 3 dans la deuxième couche 2, l'étape de formation de la deuxième couche 2 est réalisée, notamment par dépôt, un utilisant un précurseur contenant du carbone, notamment du TétraEthOxySilane (TEOS), en utilisant la technique de dépôt chimique en phase vapeur assistée par plasma (PECVD pour l'anglais « *Plasma Enhanced Chemical Vapor Déposition* »). La technique PECVD est préférée dans le cadre de la combinaison avec le TEOS car elle permet de casser plus facilement les molécules pour permettre la présence d'atomes de carbone 3 dans la deuxième couche 2. Typiquement la combinaison du dépôt en phase chimique à basse pression (LPCVD pour l'anglais « *Low Pressure Chemical Vapor Déposition* ») avec le TEOS n'est pas suffisante pour obtenir la présence d'atomes de carbone 3 dans la deuxième couche 2.

L'homme du métier peut, pour réaliser cette couche 2 comprenant des atomes de carbone, utiliser des recettes standard de dépôt d'oxyde et adapter le procédé à sa convenance. A titre d'exemple, pour un réacteur connu sous la dénomination « P5000B lamp heated », on peut utiliser les conditions suivantes : pression 7.2Torr, puissance 750W, 230 mils de distance inter électrodes, 1000 sccm d'Hélium, 1200sccm de TEOS et 1000sccm d'oxygène à 400°C. Dans ces conditions, on obtient 1 micromètre d'oxyde formant la deuxième couche 2 munie d'atomes de carbone en 74 secondes.

Dans un « Centura E réacteur DXZ », les conditions suivantes peuvent être observées : 8.2 Torr, 910W, 240 mils, 1000sccm d'Hélium, de TEOS et d'oxygène, 400°C, on obtient alors une vitesse cb dépôt de 750nm/minute.

Par mil(s), on entend une unité de mesure de longueur, égale à un millième de pouce, soit 25,4 micromètres. Le mil est aussi appelé le mil linéaire.

Pour les expériences réalisées en PECVD avec TEOS, le pourcentage atomique de carbone obtenu dans la deuxième couche 2 est inférieur à 1%.

Dans un deuxième exemple permettant la présence des atomes de carbone 3 dans la deuxième couche 2, l'étape de formation de la deuxième couche 2 peut être réalisée, notamment par dépôt, en utilisant un précurseur ne comportant pas de carbone, notamment le précurseur est du silane, et en incorporant du carbone, notamment du dioxyde de carbone, par exemple sous forme de gaz dans l'enceinte de dépôt de la deuxième couche 2. Ce deuxième exemple sera préféré dans le sens où il permet de doser la quantité de carbone alors que le TEOS ne le permet pas car il comporte une quantité prédéterminée de carbone non ajustable.

L'homme du métier peut, pour réaliser la deuxième couche 2 selon ce deuxième exemple, utiliser des recettes standard de dépôt d'oxyde et adapter le procédé à sa convenance. A titre d'exemple, dans un équipement Centura D réacteur DXZ (2.7T, 400W, 460 mils, 400°C), il est possible de faire varier les ratios de gaz de la manière suivante : 1900 sccm CO₂, 20 sccm SiH₄; 1900 sccm CO₂, 37 sccm SiH₄; 1900 sccm CO₂, 100 sccm SiH₄. Pour 20 sccm de SiH₄, on obtient 400nm d'oxyde en 134s, pour 37 sccm en 82s et pour 100 sccm en 50s.

Plus la quantité de carbone est importante, plus le taux de nanoéléments est élevé. Ainsi pour le dernier ratio de gaz de la liste de ratios, les nanoéléments ne sont plus distincts dans la matrice d'oxyde (tranche 1a) mais s'agglomèrent pour former une matrice de nanoéléments dans la matrice d'oxyde.

Comme indiqué précédemment, c'est au cours de l'étape d'exposition provoquant la formation de la première tranche 1a par oxydation de la première couche 1 que se forme chaque nanoélément 4. Autrement dit, on peut considérer que l'étape d'exposition comporte une étape de croissance dudit au moins un nanoélément 4 dans ladite première tranche 1a au cours de sa formation, la croissance dudit au moins un nanoélément 4 étant réalisée dans une direction orientée à l'opposé de la deuxième couche 2. En fait, au cours de la formation de la première tranche 1a, l'épaisseur selon la flèche F1 de la figure 3 de la première tranche 1a augmente au fur et à mesure alors que celle d'une deuxième tranche 1b correspondant au reste de la première couche 1 diminue en conséquence. Ledit nanoélément 4 s'étend alors entre deux extrémités longitudinales opposées 4a, 4b (figure 3) au sein d'une matrice d'oxyde de silicium et une des extrémités 4b, est en contact avec la deuxième tranche 1b (notamment au niveau du front d'oxydation), l'autre extrémité 4a se retrouvant à proximité de la deuxième couche 2 (l'écart avec cette deuxième couche 2 résultant de l'expansion du silicium lors de son oxydation). De préférence, entre ses deux extrémités 4a et 4b, le nanoélément 4 est noyé dans la matrice d'oxyde de silicium de la première tranche 1a.

L'étape d'exposition à l'atmosphère oxydante permet de densifier la deuxième couche 2 tout en oxydant la première couche 1 partiellement ou totalement par diffusion au travers de la deuxième couche 2. Ainsi, ce sont les espèces oxydantes de l'atmosphère d'oxydation qui diffusent à travers la deuxième couche 2 pour venir oxyder la tranche 1a. L'atmosphère oxydante comporte de l'oxygène. Typiquement pour une oxydation sèche l'atmosphère oxydante comporte par exemple 99% d'oxygène pour 1% d'azote. En oxydation humide, l'oxydation peut être obtenue classiquement à l'aide d'une torche plasma.

Selon l'invention, l'étape d'exposition comporte une étape de maintien d'une température d'oxydation à laquelle sont soumises les première et deuxième couches 1, 2 et une étape d'injection d'un gaz oxydant, notamment de l'oxygène, dans une enceinte d'oxydation dans laquelle sont placées les première et deuxième couches 1, 2. La température d'oxydation selon l'invention est comprise entre 950 °C et 1200 °Cet de préférence est de l'ordre de, ou égale à, 1050°C. Par exemple, l'étape d'exposition peut être mise en œuvre pendant une durée prédéterminée fonction des conditions de température et d'utilisation du gaz oxydant, et de préférence de l'épaisseur de la première couche 1, et de l'épaisseur souhaitée d'oxydation dans la première couche. L'homme du métier est alors apte à adapter le présent procédé à sa convenance.

Par exemple, pour une deuxième couche 2 d'oxyde de 400nm, et pour oxyder environ 100nm de polysilicium, les conditions suivantes peuvent être utilisées: 1050°C pendant 3h en atmosphère sèche ou 1050°C pendant 30minutes en atmosphère humide.

L'étape d'exposition peut être réalisée en utilisant les techniques d'oxydation sèche ou humide. La durée de l'étape d'exposition est alors fonction de la technique choisie. Typiquement, en cas d'exposition selon la technique sèche, ladite durée sera supérieure à celle de l'exposition avec la technique humide.

L'étape d'exposition peut aussi être telle que toute la première couche 1 est oxydée.

Il est ainsi possible d'obtenir des nanoéléments électriquement conducteur dans une matrice isolante d'oxyde. On a pu mesurer pour des nanoéléments (nanofils) obtenus de l'ordre de 10 nm de diamètre de section et environ 80 nm de hauteur une résistance entre 10⁷ et 10⁸ ohms.

Après l'étape d'exposition, le nanoélément 4 n'est généralement pas accessible directement car totalement enrobé. Il en résulte donc une problématique d'accessibilité dudit nanoélément 4. Autrement dit, comme illustré à la figure 3, ledit nanoélément 4 peut être recouvert au moins en partie consécutivement à sa formation lors de l'étape d'exposition, et le procédé peut comprendre une étape de dégagement d'au moins une partie recouverte dudit nanoélément 4. En fait, sur l'exemple particulier et non limitatif de la figure 3, le nanoélément 4 est complètement enrobé, d'une part, par de l'oxyde de silicium issu de la couche 2 et de l'étape d'exposition ayant mené à la formation de la première tranche 1a et, d'autre part, par une partie de la deuxième tranche 1b à partir de laquelle il s'élève consécutivement à l'étape d'exposition.

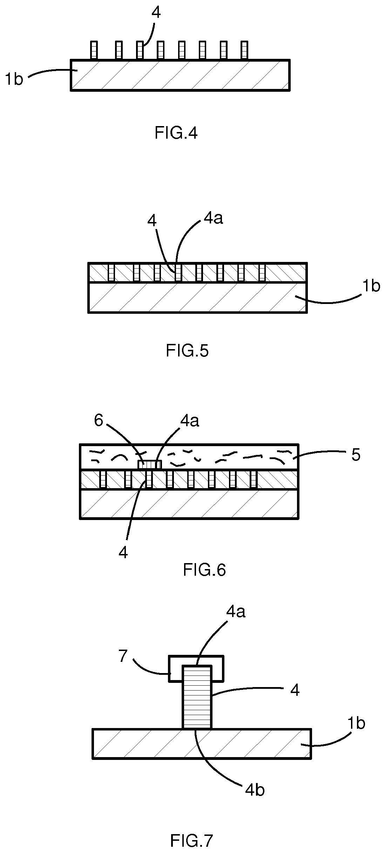

Selon une première mise en œuvre, l'étape de dégagement peut comprendre une étape de suppression de l'oxyde de silicium de la deuxième couche 2 par exemple sélectivement par rapport audit au moins un nanoélément (notamment une étape de suppression de la totalité de la deuxième couche 2) et de la partie oxydée de la première tranche 1a jusqu'à la deuxième tranche 1b non oxydée issue de la première couche 1 à partir de laquelle s'étend ledit au moins un nanoélément 4. Le résultat d'une telle suppression est visible à la figure 4. Cette suppression peut être mise en œuvre par gravure sélective chimique HF (fluorure d'hydrogène) ou HF vapeur. Par ailleurs, alternativement la partie oxydée de la première tranche 1a peut ne pas être retirée jusqu'à la deuxième tranche 1b du moment qu'une portion accessible du nanoélément 4 est de dimensions suffisante.

Selon une deuxième mise en œuvre, l'étape de dégagement peut comprendre une étape de rabotage d'au moins la deuxième couche 2 de sorte à libérer une extrémité 4a dudit au moins un nanoélément 4. En fait, la deuxième couche 2 et une partie de la tranche 1a peuvent être rabotées avant de permettre l'accès à l'extrémité 4a. Après rabotage, l'extrémité 4a du nanofil reste libre et accessible (figure 5). Cette étape de rabotage peut être effectuée par une CMP (Polissage Mécano Chimique).

Il peut être avantageux pour certaines applications, de reporter ledit au moins un nanoélément 4 sur un autre support (substrat). Par exemple, un autre support sur lequel il est impossible de faire croître un nanoélément 4 à base de silicium. Comme décrit précédemment, ledit au moins un nanoélément est obtenu naturellement enrobé dans une matrice d'oxyde de silicium (figure 3) et un report de cette couche contenant ledit au moins un nanoélément 4 sur un autre support est ainsi facilité. Sur la figure 6, cet autre support peut être représenté par l'élément référencé 5. Ce report peut s'effectuer par les moyens connus de report, par exemple un collage direct ou un collage par l'intermédiaire d'un polymère. Dans un procédé avantageux, ce report pourra s'effectuer après l'opération de rabotage visant à libérer une extrémité 4a dudit au moins un nanoélément 4. Il sera alors avantageusement possible d'éliminer, le cas échéant, le substrat support et le reste non oxydé 1b de la première couche 1 par un des procédés ou une combinaison des procédés suivants : gravure profonde, meulage (grinding), CMP (polissage mécano chimique) gravure chimique humide (par exemple par TMAH). La fin de l'enlèvement se fera avantageusement par un procédé sélectif qui ne gravera pas l'oxyde de silicium matriciel dans lequel sont présents les nanoéléments. On pourra ainsi alors dégager ledit au moins un nanoélément par les techniques précédemment décrites, totalement ou partiellement.

L'invention est aussi relative à un procédé de fabrication d'un dispositif électronique muni d'au moins un nanoélément fonctionnalisé. Un tel procédé peut avantageusement comporter une étape de mise en œuvre du procédé d'obtention tel que décrit de sorte à former ledit au moins un nanoélément, et une étape de fonctionnalisation dudit au moins un nanoélément de sorte à créer une interaction électrique dudit au moins un nanoélément avec un autre élément du dispositif.

Par exemple, le procédé d'obtention comportant une étape de rabotage d'au moins la deuxième couche 2 de sorte à libérer une extrémité 4a dudit au moins un nanoélément 4, l'étape de fonctionnalisation peut comprendre le report d'une partie 5 du dispositif au niveau de ladite extrémité 4a libérée de sorte à associer à ladite extrémité 4a libérée ledit autre élément 6 du dispositif (figure 6). Après report, ladite partie 5 peut être collée notamment à une autre partie comprenant le nanoélément 4 de sorte à maintenir l'association entre le nanoélément et l'autre élément 6 du dispositif.

Selon un autre exemple (figure 7), ledit procédé d'obtention comportant une étape de dégagement d'au moins une partie recouverte le long dudit nanoélément 4 entre deux de ses extrémités longitudinales opposées 4a, 4b, l'étape de fonctionnalisation comporte une étape de dépôt d'une couche 7 destinée à former ledit autre élément du dispositif sur au moins une portion de ladite au moins une partie dégagée du nanoélément 4 ou au niveau d'une extrémité libre 4a dudit nanoélément 4.

Par ailleurs, si ledit au moins un nanoélément est associé à un premier substrat et si ledit autre élément est associé à un deuxième substrat distinct du premier substrat, alors le procédé peut comporter une étape de transfert de l'un des substrats sur l'autre de sorte à associer ledit au moins un nanoélément audit autre élément.

Bien entendu, l'invention est aussi relative à un ou plusieurs nanoéléments obtenus selon le procédé d'obtention et/ou à un dispositif électronique issu du procédé de fabrication du dispositif électronique.

Les procédés décrits ci-avant permettent d'éviter l'utilisation de précurseurs métalliques pour la croissance des nanoéléments. De plus, dans certaines applications (par exemple transfert de nanoéléments d'un substrat A vers un substrat B), il peut être intéressant d'enrober les nanoéléments afin d'obtenir, par exemple, une couche de matrice électriquement isolante contenant des nanoéléments électriquement conducteurs ou semiconducteurs. Dès lors, selon l'approche décrite ci-avant, cet enrobage est automatiquement réalisé lors de la formation des nanoéléments, permettant de supprimer une étape technologique d'enrobage ultérieure à la formation des nanoéléments. De plus, une fois les nanoéléments créés par les moyens connus de l'art antérieur, il est délicat de les enrober sans modifier leurs propriétés, le procédé proposé ici permet de pallier cet inconvénient.

Dans la présente description, le terme nanoélément peut être remplacé par des nanoéléments. Ainsi, tout ce qui a été dit ci-dessus s'applique en remplaçant ledit au moins un nanoélément par une pluralité de nanoéléments. De la même manière chaque nanoélément peut en fait être un nanofil à base de silicium.

Le procédé selon l'invention peut permettre d'obtenir une pluralité de nanoéléments disjoints sensiblement parallèles entre eux et perpendiculaires au plan du substrat. Il est également possible d'obtenir un matériau poreux à base de silicium. En effet, comme expliqué précédemment, si la densité de nanoéléments est trop importante (notamment si la quantité de carbone introduite dans la couche 2 est importante), les nanoéléments s'agglomèrent pour former une matrice au sein de la matrice d'oxyde (oxyde de silicium de la tranche 1a). Il est ensuite possible d'éliminer sélectivement cette matrice d'oxyde (par exemple par gravure sélective chimique HF ou HF vapeur). On obtient alors une structure poreuse à base de silicium. Comme toutes les structures poreuses, cette structure présente une surface développée importante qui peut être mise à profit dans de nombreuses applications, et notamment la détection de gaz par exemple.

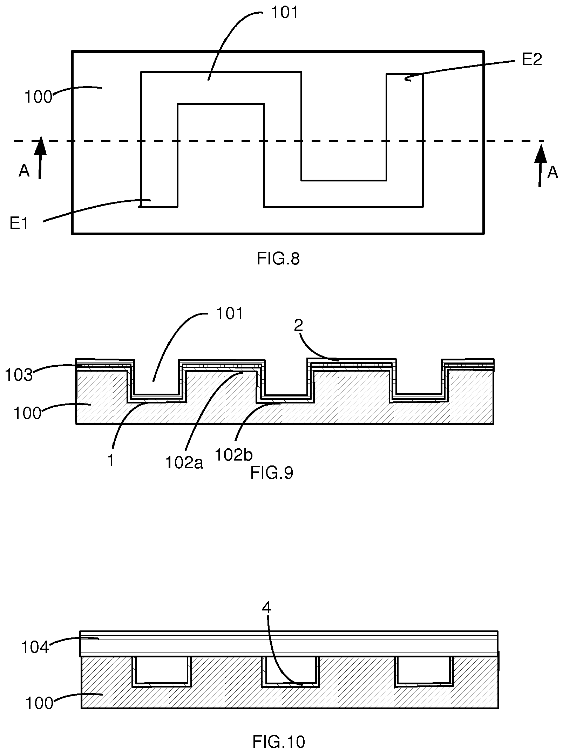

Ainsi, selon un exemple particulier illustré aux figures 8 à 10, il est possible de graver dans un substrat de silicium 100 un serpentin 101 (de l'ordre de 100 microns de profondeur) pour créer une cavité délimitée par un relief avec des parties hautes 102a et des parties en creux 102b. Ensuite, il est déposé en surface de la face gravée du substrat 101 la première couche 1 de silicium polycristallin dopé (avantageusement dopé phosphore) de l'ordre de 1 micron d'épaisseur comme précédemment décrit. On dépose alors par des techniques standard un masque 103 (par exemple de nitrure) sur (de préférence uniquement sur) les parties hautes 102a du relief recouvertes par la première couche 1. On dépose ensuite la couche d'oxyde de silicium (correspondant à la deuxième couche 2) contenant du carbone comme précédemment décrit (par exemple d'épaisseur 400nm), ce dépôt peut recouvrir le masque 103 et le reste de la première couche 1 non recouverte par le masque 103. L'étape d'exposition à l'atmosphère oxydante est alors réalisée de sorte à procéder à l'oxydation de la couche de polysilicium (première couche 1) au travers de la couche d'oxyde (deuxième couche 2). Cette oxydation n'a lieu que dans les parties 102b en creux puisque la présence du masque 103 (nitrure) au niveau des parties hautes 102a empêche l'oxydation à ce niveau. Les nanoéléments 4 sont donc créés au fond de la cavité ainsi que sur des parois de la cavité correspondant aux parties en creux 102b. Si la quantité de carbone est importante les nanoéléments 4 s'agglomèrent. Il est alors possible d'éliminer sélectivement l'oxyde (c'est-à-dire la couche d'oxyde 2 et la partie oxydée de la première couche 1 par exemple le polysilicium oxydé) et le masque 103 de nitrure, et de préférence la première couche 1 au niveau des parties hautes 102a pour obtenir des cavités dont la surface (parois et fond) est recouverte d'une couche poreuse à base de silicium (agglomérat de nanoéléments à base de silicium). On peut ensuite refermer les cavités en reportant un capot 104 en surface. En ménageant un chemin entre une entrée et une sortie aux extrémités opposées E1 et E2 (figure 8) du serpentin initial, il est alors possible de faire circuler dans le serpentin ainsi « enterré » un gaz ou un fluide à analyser en utilisant les nanoéléments 4, par exemple dans le cadre d'application à la détection ou l'analyse de gaz.

## Revendications

1. Procédé d'obtention d'au moins un nanoélément (4) à base de silicium, notamment un nanofil, **caractérisé en ce qu'**il comporte les étapes suivantes :
- fournir un substrat comprenant en surface une première couche (1) comprenant du silicium électriquement dopé dans une gamme comprise entre 10¹⁸ at cm⁻³ et 10²¹ at cm⁻³,
- former, sur la première couche (1), une deuxième couche (2) à base d'oxyde de silicium avec des atomes de carbone (3) dispersés dans ladite deuxième couche (2), la deuxième couche comportant un pourcentage atomique de carbone compris entre 0.1 % et 10%,
- exposer les première et deuxième couches (1, 2) à une atmosphère oxydante de sorte à oxyder au moins une première tranche (1a) de la première couche (1) à l'interface de ladite première couche (1) avec la deuxième couche (2) et à former ledit au moins un nanoélément (4) au niveau de ladite première tranche (1a), l'étape d'exposition à une atmosphère oxydante comportant une étape de maintien d'une température d'oxydation comprise entre 950°C et 1200°C à laquelle sont soumises les première et deuxième couches (1, 2).

2. Procédé selon la revendication précédente, **caractérisé en ce que** le silicium de la première couche (1) est du silicium polycristallin.

3. Procédé selon la revendication précédente, **caractérisé en ce qu'**il comporte une étape de dopage électrique de type n de la première couche (1) par un phosphore avec une concentration comprise entre 10¹⁹ at.cm⁻³ et 2.10²⁰ at.cm⁻³ bornes inclues.

4. Procédé selon l'une des revendications précédentes, **caractérisé en ce qu'**il comporte, avant le dopage de la première couche (1), une étape de détermination de la concentration voulue du dopant dans la première couche (1) de sorte à obtenir une densité prédéterminée de nanoéléments (4) consécutivement à l'étape d'exposition.

5. Procédé selon l'une quelconque des revendications précédentes **caractérisé en ce que** l'étape de formation de la deuxième couche (2) est réalisée en utilisant un précurseur contenant du carbone, notamment du TétraEthOxySilane, en utilisant la technique de dépôt chimique en phase vapeur assistée par plasma.

6. Procédé selon l'une quelconque des revendications 1 à 4, **caractérisé en ce que** l'étape de formation de la deuxième couche (2) est réalisée en utilisant un précurseur ne comportant pas de carbone, notamment le précurseur est du silane, et en incorporant du carbone, notamment du dioxyde de carbone.

7. Procédé selon l'une quelconque des revendications précédentes, **caractérisé en ce que** l'étape d'exposition comporte une étape de maintien d'une température d'oxydation à laquelle sont soumises les première et deuxième couches (1, 2) et une étape d'injection d'un gaz oxydant, notamment de l'oxygène, dans une enceinte d'oxydation dans laquelle sont placées les première et deuxième couches (1, 2).

8. Procédé selon la revendication précédente, **caractérisé en ce que** l'étape d'exposition est mise en œuvre pendant une durée prédéterminée fonction des conditions de température et d'utilisation du gaz oxydant.

9. Procédé selon l'une quelconque des revendications précédentes, **caractérisé en ce que** ledit nanoélément (4) étant recouvert au moins en partie consécutivement à sa formation lors de l'étape d'exposition, le procédé comprend une étape de dégagement d'au moins une partie recouverte dudit nanoélément (4).

10. Procédé selon la revendication 9, **caractérisé en ce que** l'étape de dégagement comprend une étape de suppression de l'oxyde de silicium de la deuxième couche (2) et de la partie oxydée de la première tranche (1a) jusqu'à une deuxième tranche (1b) non oxydée issue de la première couche (1) à partir de laquelle s'étend ledit au moins un nanoélément 4.

11. Procédé selon la revendication 9, **caractérisé en ce que** l'étape de dégagement comporte une étape de rabotage d'au moins la deuxième couche (2) de sorte à libérer une extrémité (4a) dudit au moins un nanoélément (4).

12. Procédé de fabrication d'un dispositif électronique muni d'au moins un nanoélément (4) fonctionnalisé, **caractérisé en ce qu'**il comporte :
- une étape de mise en œuvre du procédé d'obtention selon l'une des revendications 1 à 11 de sorte à former ledit au moins un nanoélément (4),
- une étape de fonctionnalisation dudit au moins un nanoélément (4) de sorte à créer une interaction électrique dudit au moins un nanoélément (4) avec un autre élément (6) du dispositif.

13. Procédé selon la revendication précédente, **caractérisé en ce que** ledit procédé d'obtention comportant une étape de rabotage d'au moins la deuxième couche (2) de sorte à libérer une extrémité (4a) dudit au moins un nanoélément (4), l'étape de fonctionnalisation comprend le report d'une partie (5) du dispositif au niveau de ladite extrémité libérée (4a) de sorte à associer à ladite extrémité libérée (4a) ledit autre élément (6) du dispositif.

14. Procédé selon la revendication 12, **caractérisé en ce que** ledit procédé d'obtention comporte une étape de dégagement d'au moins une partie recouverte le long dudit nanoélément (4) entre deux de ses extrémités longitudinales opposées, et **en ce que** l'étape de fonctionnalisation comporte une étape de dépôt d'une couche (7) destinée à former ledit autre élément (6) du dispositif sur au moins une portion de ladite au moins une partie dégagée du nanoélément (4).

15. Procédé selon l'une quelconque des revendications 12 à 14, **caractérisé en ce que** ledit au moins un nanoélément étant associé à un premier substrat, et ledit autre élément (6) étant associé à un deuxième substrat distinct du premier substrat, le procédé comporte une étape de transfert de l'un des substrats sur l'autre de sorte à associer ledit au moins un nanoélément (4) audit autre élément (6).

## Patentansprüche

1. Verfahren zur Herstellung mindestens eines Nanoelements (4) auf Siliziumbasis, insbesondere eines Nanodrahtes, **dadurch gekennzeichnet, dass** es die folgenden Schritte aufweist:
- Bereitstellen eines Substrats, das auf der Oberfläche eine erste Schicht (1) umfasst, die elektrisch dotiertes Silizium in einem Bereich zwischen 10¹⁸ at.cm⁻³ und 10²¹ at.cm⁻³ umfasst,
- Bilden auf der ersten Schicht (1) einer zweiten Schicht (2) auf der Basis von Siliziumoxid mit Kohlenstoffatomen (3), die in der zweiten Schicht (2) dispergiert werden, wobei die zweite Schicht einen Kohlenstoffatomanteil zwischen 0,1 % und 10 % umfasst,
- Aussetzen der ersten und der zweiten Schicht (1, 2) einer oxidierenden Atmosphäre, derart, um mindestens einen ersten Abschnitt (1a) der ersten Schicht (1) an der Grenzfläche der ersten Schicht (1) mit der zweiten Schicht (2) zu oxidieren und um das mindestens eine Nanoelement (4) an dem ersten Abschnitt (1a) zu bilden, wobei der Schritt des Aussetzens einer oxidierenden Atmosphäre einen Schritt des Aufrechterhaltens einer Oxidationstemperatur zwischen 950 °C und 1.200 °C aufweist, der die erste und die zweite Schicht (1, 2) ünterworfen werden.

2. Verfahren nach dem vorhergehenden Anspruch, **dadurch gekennzeichnet, dass** das Silizium der ersten Schicht (1) polykristallines Silizium ist.

3. Verfahren nach dem vorhergehenden Anspruch, **dadurch gekennzeichnet, dass** es einen Schritt des elektrischen Dotierens vom n-Typ der ersten Schicht (1) durch einen Phosphor mit einer Konzentration zwischen 10¹⁹ at. cm⁻³ und 2.10²⁰ at.cm⁻³, einschließlich der Klemmen, aufweist.

4. Verfahren nach einem der vorhergehenden Ansprüche, **dadurch gekennzeichnet, dass** es vor dem Dotieren der ersten Schicht (1) einen Schritt des Bestimmens der gewünschten Konzentration des Dotierungsmittels in der ersten Schicht (1) derart aufweist, um eine vorbestimmte Dichte an Nanoelementen (4) nach dem Schritt des Aussetzens zu erhalten.

5. Verfahren nach einem der vorhergehenden Ansprüche, **dadurch gekennzeichnet, dass** der Schritt des Bildens der zweiten Schicht (2) unter Verwendung eines kohlenstoffhaltigen Vorläufers, insbesondere Tetraethoxysilan, unter Verwendung der plasmaunterstützten chemischen Gasphasenabscheidungstechnik durchgeführt wird.

6. Verfahren nach einem der Ansprüche 1 bis 4, **dadurch gekennzeichnet, dass** der Schritt des Bildens der zweiten Schicht (2) unter Verwendung eines Vorläufers, der keinen Kohlenstoff umfasst, wobei der Vorläufer insbesondere Silan ist, und indem Kohlenstoff, insbesondere Kohlendioxid, eingearbeitet wird, durchgeführt wird.

7. Verfahren nach einem der vorhergehenden Ansprüche, **dadurch gekennzeichnet, dass** der Schritt des Aussetzens einen Schritt des Aufrechterhaltens einer Oxidationstemperatur, der die erste und die zweite Schicht (1, 2) ünterworfen werden, und einen Schritt des Einspritzens eines Oxidationsgases, insbesondere Sauerstoff, in einen Oxidationsbehälter aufweist, in dem die erste und die zweite Schicht (1, 2) angeordnet werden.

8. Verfahren nach dem vorhergehenden Anspruch, **dadurch gekennzeichnet, dass** der Schritt des Aussetzens während einer vorbestimmten Zeit durchgeführt wird, die von den Temperatur- und Verwendungsbedingungen des Oxidationsgases abhängt.

9. Verfahren nach einem der vorhergehenden Ansprüche, **dadurch gekennzeichnet, dass**, nachdem das Nanoelement (4) mindestens teilweise nach seinem Bilden bei dem Schritt des Aussetzens bedeckt wird, das Verfahren einen Schritt des Freilegens von mindestens einem bedeckten Teil des Nanoelements (4) aufweist.

10. Verfahren nach Anspruch 9, **dadurch gekennzeichnet, dass** der Schritt des Freilegens einen Schritt des Entfernens des Siliziumoxids von der zweiten Schicht (2) und von dem oxidierten Teil des ersten Abschnitts (1a) bis zu einem zweiten nicht oxidierten Abschnitt (1b) aufweist, der aus der ersten Schicht (1) hervorgeht, von der aus sich das mindestens eine Nanoelement 4 erstreckt.

11. Verfahren nach Anspruch 9, **dadurch gekennzeichnet, dass** der Schritt des Freilegens einen Schritt des Abschleifens von mindestens der zweiten Schicht (2) derart aufweist, um ein Ende (4a) des mindestens einen Nanoelements (4) freizugeben.

12. Verfahren zur Herstellung einer elektronischen Vorrichtung, die mit mindestens einem funktionalisierten Nanoelement (4) versehen ist, **dadurch gekennzeichnet, dass** es aufweist:
- einen Schritt des Umsetzens des Verfahrens zur Herstellung nach einem der Ansprüche 1 bis 11, derart, um das mindestens eine Nanoelement (4) zu bilden,
- einen Schritt des Funktionalisierens des mindestens einen Nanoelements (4), derart, um eine elektrische Interaktion des mindestens einen Nanoelements (4) mit einem anderen Element (6) der Vorrichtung zu erzeugen.

13. Verfahren nach dem vorhergehenden Anspruch, **dadurch gekennzeichnet, dass**, nachdem das Verfahren zur Herstellung einen Schritt des Abschleifens von mindestens der zweiten Schicht (2) derart aufweist, um ein Ende (4a) des mindestens einen Nanoelements (4) freizugeben, der Schritt des Funktionalisierens das Verschieben eines Teils (5) der Vorrichtung an dem freigegebenen Ende (4a) derart aufweist, um das andere Element (6) der Vorrichtung mit dem freigegebenen Ende (4a) zu verbinden.

14. Verfahren nach Anspruch 12, **dadurch gekennzeichnet, dass** das Verfahren zur Herstellung einen Schritt des Freilegens von mindestens einem bedeckten Teil entlang des Nanoelements (4) zwischen zwei seiner gegenüberliegenden Längsenden aufweist und dadurch, dass der Schritt des Funktionalisierens einen Schritt des Aufbringens einer Schicht (7) aufweist, die dazu bestimmt ist, das andere Element (6) der Vorrichtung auf mindestens einem Abschnitt des mindestens einen freigelegten Teils des Nanoelements (4) zu bilden.

15. Verfahren nach einem der Ansprüche 12 bis 14, **dadurch gekennzeichnet, dass**, nachdem das mindestens eine Nanoelement mit einem ersten Substrat verbunden ist und das andere Element (6) mit einem zweiten Substrat verbunden ist, das von dem ersten Substrat verschieden ist, das Verfahren einen Schritt des Übertragens von einem der Substrate auf das andere derart aufweist, um das mindestens eine Nanoelement (4) mit dem anderen Element (6) zu verbinden.

## Claims

1. Process for producing at least one silicon-based nanoelement (4), in particular a nanowire, **characterized in that** it comprises the following stages:
- providing a substrate comprising, at the surface, a first layer (1) comprising electrically doped silicon within a range between 10¹⁸ at.cm⁻³ and 10²¹ at.cm⁻³,
- forming, on the first layer (1), a second layer (2) based on silicon oxide with carbon atoms (3) dispersed in the said second layer (2), the second layer comprising an atomic percentage between 0,1% and 10%
- exposing the first and second layers (1, 2) to an oxidizing atmosphere, so as to oxidize at least a first section (1a) of the first layer (1) at the interface of the said first layer (1) with the second layer (2) and to form the said at least one nanoelement (4) at the said first section (1a), the exposure stage to an oxidizing atmosphere comprising a stage of maintaining an oxidation temperature between 950°C and 1200°C to which the first and second layers (1, 2) are subjected.

2. Process according to the preceding claim, **characterized in that** the silicon of the first layer (1) is polycrystalline silicon.

3. Process according to the preceding claim, **characterized in that** it comprises a stage of n-type electrical doping of the first layer (1) by a phosphorus with a concentration of between 10¹⁹ at.cm⁻³ and 2 × 10²⁰ at.cm⁻³, limits included.

4. Process according to one of the preceding claims, **characterized in that** it comprises, before the doping of the first layer (1), a stage of determination of the desired concentration of the dopant in the first layer (1) so as to obtain a predetermined density of nanoelements (4) following the exposure stage.

5. Process according to any one of the preceding claims, **characterized in that** the stage of formation of the second layer (2) is carried out by using a carbon-comprising precursor, in particular TetraEthOxySilane, the plasma enhanced chemical vapor deposition technique being used.

6. Process according to any one of Claims 1 to 4, **characterized in that** the stage of formation of the second layer (2) is carried out by using a precursor which does not comprise carbon; in particular the precursor is silane, and by incorporating carbon, in particular carbon dioxide.

7. Process according to any one of the preceding claims, **characterized in that** the exposure stage comprises a stage of maintaining an oxidation temperature to which the first and second layers (1, 2) are subjected and a stage of injection of an oxidizing gas, in particular oxygen, into an oxidation chamber in which the first and second layers (1, 2) are placed.

8. Process according to the preceding claim, **characterized in that** the exposure stage is carried out for a predetermined period of time which is a function of the conditions of temperature and of use of the oxidizing gas.

9. Process according to any one of the preceding claims, **characterized in that**, as the said nanoelement (4) is covered at least in part following its formation during the exposure stage, the process comprises a stage of freeing at least a covered part of the said nanoelement (4).

10. Process according to Claim 9, **characterized in that** the freeing stage comprises a stage of removal of the silicon oxide of the second layer (2) and of the oxidized part of the first section (1a) as far as a second nonoxidized section (1b) resulting from the first layer (1) from which extends the said at least one nanoelement (4).

11. Process according to Claim 9, **characterized in that** the freeing stage comprises a stage of planing down at least the second layer (2) so as to release an end (4a) of the said at least one nanoelement (4).

12. Process for the manufacture of an electronic device provided with at least one functionalized nanoelement (4), **characterized in that** it comprises:
- a stage of carrying out the production process according to one of Claims 1 to 11, so as to form the said at least one nanoelement (4),
- a stage of functionalization of the said at least one nanoelement (4), so as to create an electrical interaction of the said at least one nanoelement (4) with another element (6) of the device.

13. Process according to the preceding claim, **characterized in that**, as the said production process comprises a stage of planing down at least the second layer (2) so as to release an end (4a) of the said at least one nanoelement (4), the functionalization stage comprises the relocation of a part (5) of the device at the said released end (4a) so as to combine, with the said released end (4a), the said other element (6) of the device.

14. Process according to Claim 12, **characterized in that** the said production process comprises a stage of freeing at least a covered part along the said nanoelement (4) between two of its opposite longitudinal ends and **in that** the functionalization stage comprises a stage of deposition of a layer (7) intended to form the said other element (6) of the device on at least a portion of the said at least a freed part of the nanoelement (4).

15. Process according to any one of Claims 12 to 14, **characterized in that**, as the said at least one nanoelement is combined with a first substrate and as the said other element (6) is combined with a second substrate distinct from the first substrate, the process comprises a stage of transfer of one of the substrates onto the other so as to combine the said at least one nanoelement (4) with the said other element (6).
